Europäisches Patentamt

European Patent Office

Office européen des brevets

(19)

(11) Numéro de publication: **0 039 258
B1**

(12) **FASCICULE DE BREVET EUROPEEN**

(45) Date de publication du fascicule du brevet:
03.07.85

(21) Numéro de dépôt: 81400432.1

(22) Date de dépôt: 20.03.81

(51) Int. Cl.⁴: **G 06 F 5/00**, G 06 F 15/20

(54) **Dispositif pour la mémorisation d'états logiques de processus.**

(30) Priorité: **09.04.80 FR 8007913**

(43) Date de publication de la demande:
**04.11.81 Bulletin 81/44**

(45) Mention de la délivrance du brevet:
**03.07.85 Bulletin 85/27**

(84) Etats contractants désignés:
**CH DE FR GB IT LI NL SE**

(56) Documents cités:
**FR - A - 2 304 123
US - A - 3 883 847**

(73) Titulaire: **COMPAGNIE INTERNATIONALE POUR
L'INFORMATIQUE CII - HONEYWELL BULL (dite
CII-HB), 94, avenue Gambetta, F-75020 Paris (FR)**

(72) Inventeur: **Ugon, Michel, 94, avenue Gambetta,
F-75020 Paris (FR)**
Inventeur: **Herve, Robert Jean Louis Anthime, 94, avenue
Gambetta, F-75020 Paris (FR)**

(74) Mandataire: **Doireau, Marc, CII-Honeywell
Bull 94, avenue Gambetta Boîte Postale 33,
F-75960 Paris cedex 20 (FR)**

EP 0 039 258 B1

## Description

La présente invention concerne un dispositif électronique permettant de mémoriser les états logiques de processus au cours de leur déroulement dans le temps.

Il est connu des mémoires à accès protégé dont le but principal est de mémoriser des informations confidentielles ou secrètes. L'accès dans ces mémoires est contrôlé par des logiques spécialisées qui s'interposent entre celles-ci et le milieu extérieur. Un exemple de réalisation d'une logique d'accès est décrit dans le brevet français n° 2 401 459 de la demanderesse. Dans cette demande la logique d'accès est constituée d'un microprocesseur, l'accès est obtenu sur présentation d'un mot de passe correct.

Dans beaucoup d'applications, il est nécessaire de mémoriser le nombre d'erreurs, le nombre d'accès ou d'apparition d'évènements illégaux. Dans les exemples de réalisation les plus connus, la façon habituelle d'enregistrer de tels évènements consiste à les enregistrer dans une mémoire permanente ou de les compter à l'aide de compteurs spécialisés utilisant une mémoire effaçable électriquement. Une description de ces dispositifs est donnée dans le brevet français n° 2 460 506 déposé également au nom de la demanderesse.

Cette méthode présente au moins trois inconvénients. En premier lieu, elle nécessite une occupation de la mémoire importante, en deuxième lieu la capacité de comptage est limitée à la capacité maximale du compteur et ne peut être modifiée même s'il reste de la place disponible dans la mémoire, et enfin le nombre d'évènements enregistrés dans les mémoires permanentes ne peut être ni diminué, ni annulé.

Le but de la présente invention est d'éliminer ces inconvénients en supprimant les différentes zones de comptage décrites dans les deux demandes précitées et en leur substituant une mémoire permanente ou non, désignée ci-après par «mémoire d'états» dans laquelle toute la capacité de la mémoire peut être utilisée et où le passage d'un état de processus à un autre s'effectue par simple examen de la mémoire d'états.

Le dispositif de mémorisation d'états logiques selon l'invention est basé sur le principe de la mémorisation de suites de configurations binaires correspondant à chaque état logique, la longueur des configurations variant en fonction des types d'états que peuvent prendre un processus et étant d'autant plus courte qu'elle correspond à des états pouvant être les plus fréquemment rencontrés.

Un tel principe est indiqué dans le préambule du brevet US n° 3 883 847.

L'invention propose donc un dispositif pour la mémorisation d'états logiques d'un processus comprenant une mémoire associée à des moyens d'écriture et de lecture d'informations dans ladite mémoire, lesdites informations étant représentatives de l'état du processus, ladite mémoire étant adressée à partir d'un registre d'adresse et étant connectée au registre de mémoire pour recevoir le contenu d'une information à écrire ou à lire en mémoire aux emplacements sélectionnés par les moyens d'adressage, du type comprenant des moyens de codage des états possibles du processus, les états d'un processus codé par les moyens de codage étant représentés dans la forme d'une suite de configurations binaires de longueur variable en fonction de chaque état, les longueurs desdites configurations étant d'autant plus courtes qu'elles correspondent à des états possibles du processus se produisant le plus fréquemment, caractérisé en ce que les états successifs du processus sont écrits et analysés dans ladite mémoire au moyen d'une fenêtre glissante d'écriture-lecture d'une longueur fonction du nombre d'états possibles du processus, cette fenêtre étant située dans la mémoire de façon que tous les chiffres binaires la précédant soient dans le même état et que tous ceux qui la suivent soient dans l'état opposé; le contenu de la fenêtre pouvant avoir une configuration binaire mixte c'est à dire différente des deux précédentes; les différents états étant représentés par des champs variables à l'intérieur et à partir du début de la fenêtre, un champ ayant un nombre de positions binaires d'autant moins élevé que l'état qu'il représente se produit plus fréquemment, le passage d'un état à un état suivant se faisant sans décalage de la fenêtre, alors que pour le passage d'un état à un état précédent, la fenêtre est décalée d'un nombre de positions binaires d'autant plus faible que ledit état précédent se produit plus fréquemment, avec un décalage maximum égal à la longueur de la fenêtre.

L'invention sera mieux comprise à l'aide de la description faite au regard des dessins qui va suivre.

La figure 1 est une représentation simplifiée du dispositif incorporant l'invention.

La figure 2 représente un diagramme d'états d'un processus.

La figure 3 est une représentation de la fenêtre d'états.

La figure 4 est un bloc diagramme illustrant le déroulement d'un processus industriel auquel peut s'appliquer l'invention.

La figure 5 représente un graphe des états du processus industriel illustré à la figure 4.

La figure 6 représente une table des configurations binaires utilisée pour le codage des états de la figure 5.

La figure 7 montre une réalisation du dispositif de mémorisation selon l'invention.

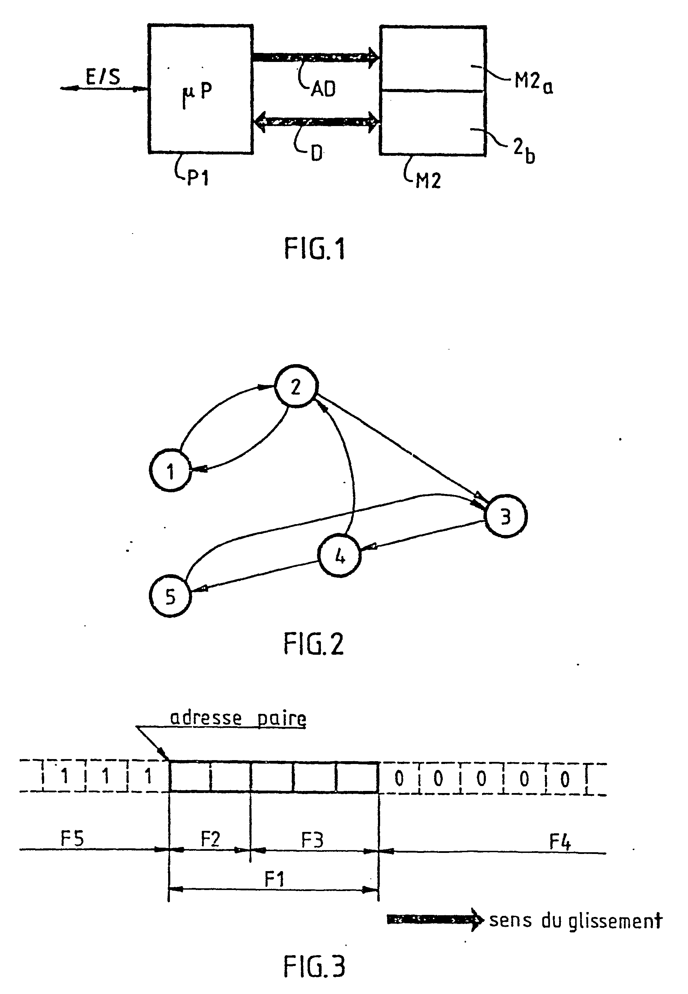

Le dispositif incorporant l'invention montré à la figure 1 se compose d'une logique de commande $P_1$ qui commande les accès à la mémoire $M_2$ en lecture comme en écriture par l'intermédiaire de ses bus d'adresse AD et données D. Une réalisation possible de l'invention pourra s'effectuer à l'aide du microprocesseur décrit dans le brevet français n° 2 461 301 de la demanderesse.

L'accès du milieu extérieur à la mémoire s'effectue à l'aide de la porte spécialisée d'entrée-sortie E/S. La mémoire $M_2$ est partagée en deux zones, une zone de travail $M2_a$ et une zone réservée à la mémoire d'états $M2_b$.

La figure 2 illustre le fonctionnement du dispositif de mémorisation d'état logique dans une application particulière où le processus contrôlé présente 5 états stables. Ce graphe fait apparaître les règles de changement d'état du processus. Seules les transitions suivantes sont autorisées.

Etat 1 vers Etat 2
Etat 2 vers Etat 1
Etat 2 vers Etat 3
Etat 3 vers Etat 4
Etat 4 vers Etat 2
Etat 4 vers Etat 5
Etat 5 vers Etat 3.

Parmi les 5 états possibles du processus représentés à la figure 2 un certain nombre peut être considéré comme obtenu séquentiellement au cours d'un fonctionnement normal (Etat 1 et 2 par exemple) alors que les états restants 3, 4 et 5 sont obtenus par exception, lorsqu'un évènement (externe) anormal se produit. Le principe de l'invention consiste à mémoriser l'état présent du processus dans la mémoire d'état $M2_b$ de la figure 1 à l'intérieur d'une zone F (ou fenêtre), de 5 bits consécutifs comme cela est représenté à la figure 3. On comprendra que l'exemple qui est décrit ici ne se limite pas à contrôler un processus limité à 5 états possibles, pour un processus à n états la zone de mémoire F devrait comporter au plus n bits consécutifs. La zone F, constitue une fenêtre de mémoire qui peut être lue et écrite à l'aide de la logique de commande $P_1$. La fenêtre $F_1$ est précédée d'une zone totalement vierge $F_4$ et suivie d'une zone totalement écrite $F_{(5)}$, comme cela sera expliqué plus loin, la fenêtre est déplaçable dans un seul sens dans la mémoire d'états. Dans l'exemple de la figure 3, la zone $F_4$ ne contient que des bits dans l'état 0 alors que ceux de la zone $F_5$ se trouvent tous à l'état 1.

La fenêtre $F_1$ se décompose en deux zones, une zone $F_2$ d'états normaux (2 bits) et une zone $F_3$ d'états anormaux (3 bits). Dans le cas présent, l'adresse de début de la fenêtre est toujours paire dans la mémoire d'états comme cela sera expliqué plus loin. D'après ce qui précède, la convention suivante est adoptée pour coder les états normaux.

| | | | | | | | | |
|---|---|---|---|---|---|---|---|---|
| Fenêtre matérialisant l'état 1 | 1 | 1 | 0 | 0 | 0 | 0 | 0 | 0 | 0 |
| Fenêtre matérialisant l'état 2 | 1 | 1 | 1 | 0 | 0 | 0 | 0 | 0 | 0 |
| Retour de l'état 2 dans l'état 1 | 1 | 1 | 1 | 0 | 0 | 0 | 0 | 0 |

De cette façon le retour à l'état 1 en partant de l'état 2 est possible par glissement de la fenêtre à l'adresse paire suivante et écriture d'un bit.

Dans le cas des états anormaux, les codes adoptés peuvent être les suivants:

| Etat 3 | 1 | 1 | 1 | 0 | 1 | 0 | 0 | 0 | 0 | 0 |
| Etat 4 | 1 | 1 | 1 | 0 | 1 | 0 | 1 | 0 | 0 | 0 |
| Etat 5 | 1 | 1 | 1 | 0 | 1 | 1 | 1 | 0 | 0 | 0 |

Dans ces conditions le passage de l'état 4 à l'état 2 s'effectue en écrivant 2 bits et en décalant la fenêtre de 4 positions binaires.

De même le passage de l'état 5 à l'état 3 s'obtient en écrivant 2 bits et en décalant la fenêtre de 4 positions binaires.

Selon ce principe, la fenêtre $F_1$ glisse d'une longueur de 2 bits dans le passage d'un état normal à un autre état normal et de 4 bits entre un état quelconque et un état anormal ou réciproquement.

L'adresse de la fenêtre est cadrée à gauche sur la première paire de configurations binaires rencontrée en balayant la mémoire d'états de gauche à droite.

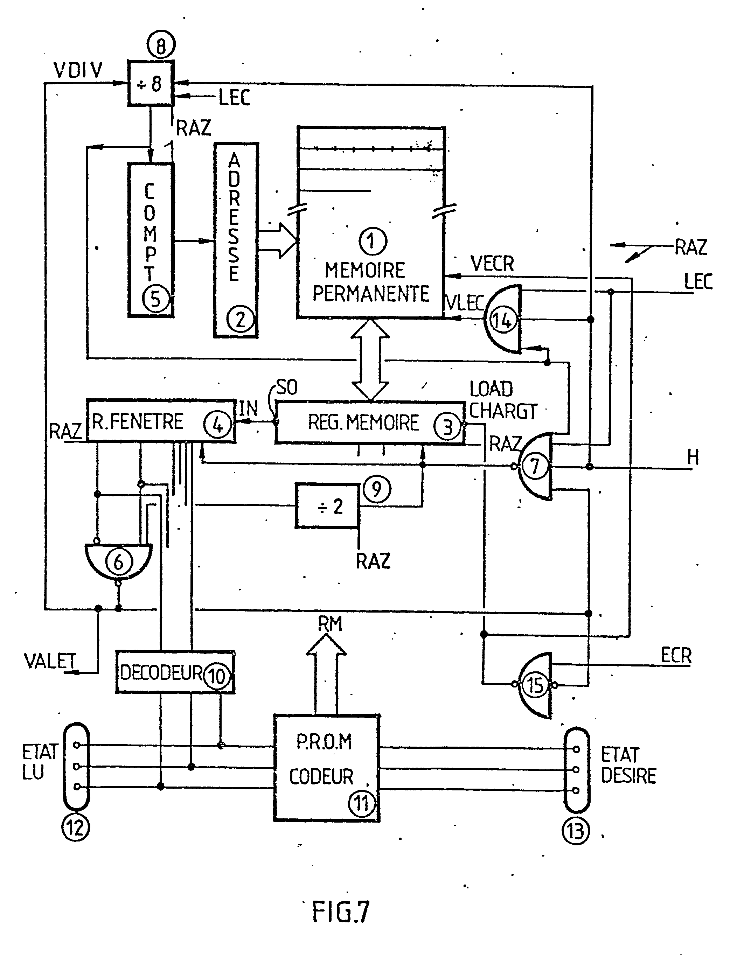

La réalisation du dispositif de mémorisation conformément au principe qui vient d'être décrit est montrée sur la figure 7. Ce dispositif comprend une mémoire permanente 1 effaçable ou non de types FAMOS, PROM, MNOS ou équivalents. Ces types de mémoire sont décrits dans le livre intitulé «les microprocesseurs, techniques et applications» par RODNAY ZAKS et PIERRE LE BEUX édité par SYBEX 313 rue Lecourbe 75015 PARIS. La mémoire 1 est adressée par le registre d'adresse 2. Les données à écrire ou à lire dans la mémoire 1 sont recueillies dans un registre de données bidirectionnel 3 monté en registre à décalage. La sortie SO du registre 3 est reliée à l'entrée IN d'un autre registre à décalage 4 destiné à recevoir la fenêtre d'analyse des états de processus selon l'invention. Les sorties parallèles de ce registre d'état 4 sont appliquées à l'entrée d'un décodeur d'états 10 dont les sorties sont reliées à un codeur 11. Le codeur 11 peut être réalisé à l'aide de mémoires type PROM ou ROM, sa fonction est de déterminer le codage de la fenêtre d'état en fonction de l'état décodé par le décodeur 10 après l'opération de lecture de la mémoire 1 et de l'état désiré que l'on veut obtenir. L'état lu dans la mémoire 1 et traduit par le décodeur 10 apparait sur les sorties 12 du dispositif. L'état désiré qui est transmis de l'extérieur du dispositif par les entrées 13. Les entrées du registre d'adresses 2 sont directement reliées aux sorties d'un compteur 5 dont la progression est assurée par les signaux délivrés par un diviseur d'impulsions 8 de rapport 8. Le diviseur 8 compte les impulsions d'horloge qui sont appliquées à son entrée lorsqu'elles sont validées par la sortie de la porte 6 et le signal LEC (lecture) appliqué de l'extérieur du dispositif. Le diviseur par 8 permet l'adressage d'octets dans la mémoire 1. La porte 6 est connectée respectivement par deux de ses entrées, une entrée normale et une entrée complémentée, aux deux sorties poids fort du registre fenêtre 4 et est connectée par une troisième entrée à un diviseur 9 de rapport 2, dont l'entrée reçoit les impulsions d'horloge 4 délivrées par la porte «non et» 7, qui les retransmet également sur les entrées d'horloge des registres à décalage 3 et 4, pour assurer le décalage à gauche des informations contenues dans ces registres. La porte «non et» 7 est connectée, par une entrée à la sortie du diviseur 8, par une entrée à la liaison de commande de lecture provenant de l'extérieur du dispositif, par une autre entrée à la liaison transmettant le signal d'horloge H et provenant de l'extérieur du dispositif et par une dernière entrée à la sortie de la porte 6 générant le signal VALET. La mémoire 1 est commandée en lecture par le signal VLEC émis par la sortie de la porte «non et» 14 qui est connectée, par une première entrée à la sortie du diviseur 8, par une deuxième entrée à la liaison d'horloge H qui reçoit sur une troisième entrée le signal de lecture LEC. La mémoire 1 est commandée en écriture par la sortie de la porte «non et» 15 qui reçoit sur une première entrée le signal ECR d'écriture transmis de l'extérieur du dispositif et sur une deuxième entrée le signal VALET émis par la sortie de la porte 6. La sortie de la porte 15 commande également le chargement du registre de mémoire 3. Le signal RAZ est transmis de l'extérieur du dispositif et assure la remise à zéro de l'ensemble des registres diviseurs et compteurs du dispositif.

Le fonctionnement du dispositif est le suivant: au départ une remise à zéro générale initialise les compteurs, diviseurs et registres du dispositif. Deux types de fonctionnement peuvent avoir lieu. Le premier peut consister à lire l'état d'un processus mémorisé dans le dispositif. Dans ce cas, le registre fenêtre 4 étant au départ à zéro, la sortie de la porte 6 délivre un signal à l'état 1 logique qui valide la porte 7. Dès que le signal de lecture LEC est appliqué le registre de mémoire 3 est chargé par le premier octet sortant de la mémoire pendant le premier pas d'horloge H grâce à la porte 14. Les sept impulsions d'horloge suivantes n'ont pas d'autres effets que de faire progresser le diviseur 8. Les huit impulsions suivantes décalent le registre 3 dans le registre 4, dont les deux positions de bits de poids forts sont testés en permanence par la porte 6 validée par le diviseur par deux 9. Deux cas peuvent alors se présenter.

1er cas: La porte 6 ne détecte aucune coïncidence et l'octet lu de la mémoire ne correspond pas à la fenêtre d'état recherchée, dans ce cas le deuxième mot (octet) est chargé dans le registre 3 et le processus se poursuit.

2ème cas: Une coïncidence est détectée par la porte 6, la porte 7 ainsi que le diviseur 8 sont alors bloqués et arrêtés par le signal VALET. En conséquence, le compteur 5 n'évolue plus, figeant l'adresse contenue dans le registre 2 ainsi que la valeur de la fenêtre contenue dans le registre fenêtre 4. Le décodeur 10 établit alors une correspondance numérique entre la configuration binaire dans le registre 4 et l'état lu dans la mémoire. Bien entendu cet état ne pourra être pris en compte par le milieu extérieur au dispositif que sur validation du signal VALET.

Le deuxième type de fonctionnement est celui de l'écriture dans la mémoire 1 mais son existence est subordonnée à l'exécution au préalable de la séquence de lecture décrite précédemment. Il suffira alors d'appliquer l'indicatif de l'état désiré en 13. Cet état constitue l'entrée d'une partie de l'adresse du codeur 11, réalisé par exemple avec une mémoire PROM, qui en fonction de l'état lu délivré par le décodeur 10 constituant la deuxième partie d'adresse, délivre la configuration binaire à écrire dans le registre de mémoire 3. Cette configuration binaire est envoyée en parallèle dans le registre 3 sur l'ordre d'écriture ECR qui doit subsister le temps nécessaire lié à la technologie de la mémoire. La réalisation du dispositif qui vient d'être décrit pourra être exécutée en utilisant les procédés de fabrication de composants électroniques à haute intégration type LSI de façon à rendre le dispositif aisément transportable. Une application du dispositif qui vient d'être décrit peut être la suivante.

Il existe de nombreux cas où il est nécessaire de contrôler qu'un certain nombre d'actions ont été effectuées dans un ordre déterminé avec possibilité de «retour en arrière», c'est-à-dire qu'il est possible de recommencer l'une des actions, si celle-ci n'a pas été éxécutée correctement ou d'éliminer des cas marginaux.

Un exemple peut être donné par le suivi de pièces devant subir des traitements divers en des lieux différents.

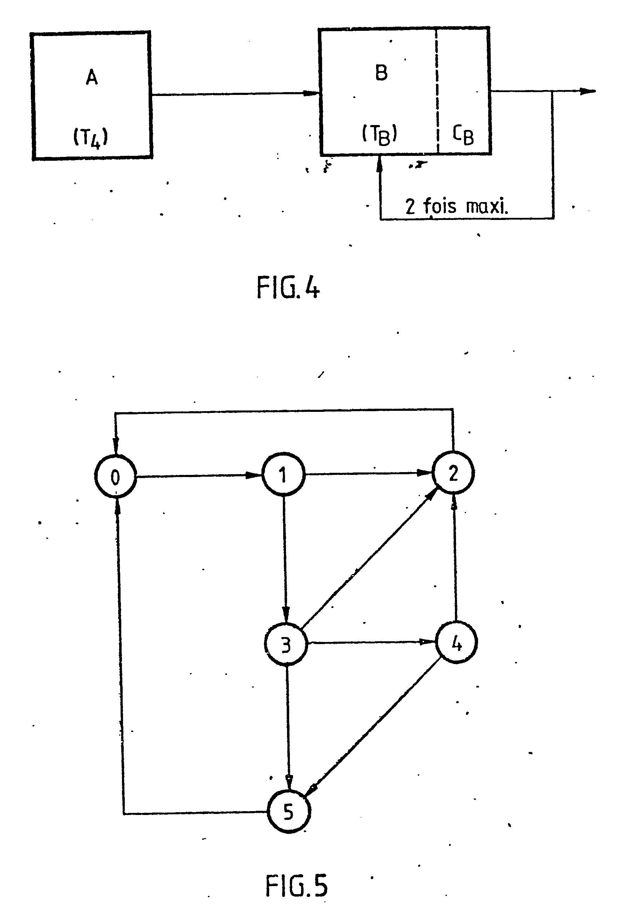

Considérons le cas de plusieurs usines spécialisées participant à la réalisation d'un produit P (voir figure 4) réalisé suivant un processus de façon sûre, c'est-à-dire subir avec certitude un enchaînement donné d'opérations.

Dans l'exemple simple qui va suivre P doit subir dans l'usine A une transformation $T_A$, par exemple un usinage sur une machine spéciale.

P doit ensuite être traité chimiquement dans l'usine B qui possède un centre d'analyse ($C_B$). Si cette analyse est négative la pièce doit subir à nouveau le traitement, et ceci, deux fois de suite au maximum, après quoi la pièce est définitivement rebutée.

Le contrôle physique d'un grand nombre de pièces transitant entre les différents postes peut être avantageusement fait par un support électronique mémorisant les états de la pièce auquel il est associé.

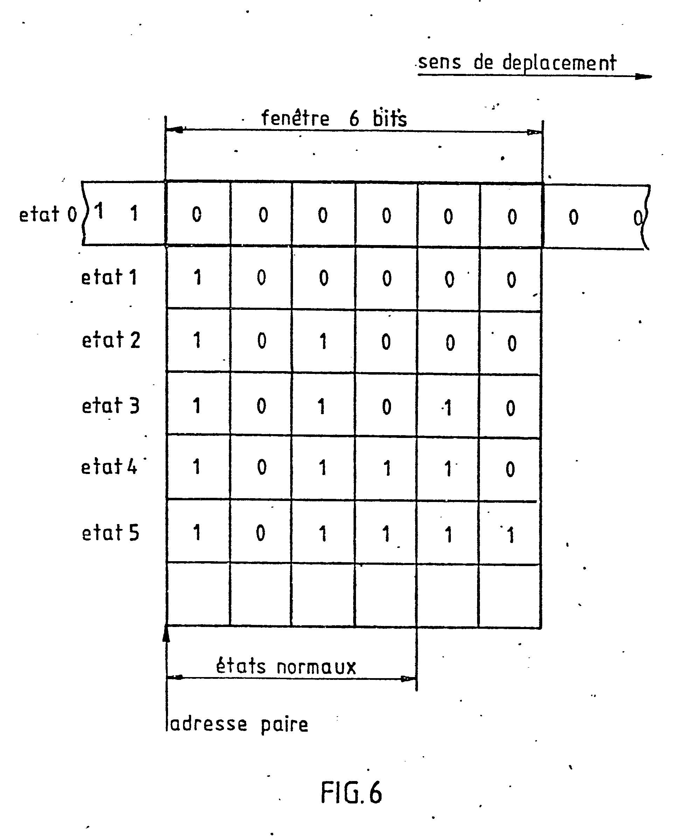

On voit facilement sur cet exemple simple que le cheminement de la pièce peut être caractérisé par 5 états (figure 5).

Le support enregistre à chaque stade, dans sa mémoire permanente l'avancement de la pièce. L'enregistrement proprement dit étant fait par une machine d'écriture connectée au support.

Dans le cas qui nous occupe, les 5 états sont les suivants:

Etat 0    Etat de départ – Pièce non traitée
Etat 1    Pièce traitée en A
Etat 2    Pièce traitée en B acceptée

Etat 3     Pièce refusée une fois en $C_B$
Etat 4     Pièce refusée deux fois en $C_B$
Etat 5     Pièce rebutée.

Ces cinq états peuvent être enregistrés suivant la méthode décrite précédemment dans la mémoire permanente par l'intermédiaire de la machine d'écriture.

Lorsque la pièce a atteint la fin du traitement, le support correspondant peut être affecté à une autre pièce (retour à l'état 0) et le cycle peut être exécuté à nouveau.

Les configurations binaires utilisées sont représentées figure 6.

La fenêtre possède une largeur de 6 bits pour analyser la mémoire.

On voit donc sur cet exemple, et en reprenant le graphe des états de la figure 5 que le nombre de bits à écrire pour passer d'un état dans un autre est donné par le tableau suivant:

| vers<br>de | 0 | 1 | 2 | 3 | 4 | 5 |
|---|---|---|---|---|---|---|
| 0 | 0 | 1 | – | – | – | – |
| 1 | – | 0 | 1 | 2 | – | – |
| 2 | 2 | – | 0 | 1 | – | – |
| 3 | – | – | 1 | 0 | 1 | 2 |
| 4 | – | – | 2 | – | 0 | 1 |
| 5 | 1 | 1 | – | – | – | 0 |

Ceci montre:
– que le passage d'un état dans un autre est caractérisé par l'écriture de 2 bits au maximum
– que les états normaux 0, 1 et 2 n'utilisent que 4 bits de la mémoire
– que les états anormaux utilisent 6 bits
– les retours aux états antérieurs 0 et 2 s'effectuent par des décalages de la fenêtre de 2, 4 et 6 bits.

Il va de soi que le mode de réalisation qui vient d'être donné de l'invention n'est nullement limitatif, l'homme de l'art pourra concevoir d'autres dispositifs de structures différentes mais ayant des fonctions identiques à celles décrites dans la présente demande. En particulier, ces fonctions pourront être réalisées à l'aide de logique microprogrammable ou programmable sans que l'idée même de l'invention s'en trouve modifiée.

**Revendications**

1. Dispositif pour la mémorisation d'états logiques d'un processus comprenant une mémoire (1) associée à des moyens d'écriture et de lecture d'informations dans ladite mémoire (1), lesdites informations étant représentatives de l'état du processus, ladite mémoire (1) étant adressée à partir d'un registre d'adresse (2) et étant connectée au registre de mémoire (3) pour recevoir le contenu d'une information à écrire ou à lire en mémoire aux emplacements sélectionnés par les moyens d'adressage (2), du type comprenant des moyens de codage (11) des états possibles du processus, les états d'un processus codé par les moyens de codage (11) étant représentés dans la forme d'une suite de configurations binaires de longueur variable en fonction de chaque état, les longueurs desdites configurations étant d'autant plus courtes qu'elles correspondent à des états possibles du processus se produisant le plus fréquemment, caractérisé en ce que les états successifs du processus sont écrits et analysés dans ladite mémoire (1) au moyen d'une fenêtre (F) glissante d'écriture-lecture d'une longueur fonction du nombre d'états possibles du processus, cette fenêtre (F) étant située dans la mémoire (1) de façon que tous les chiffres binaires la précédant soient dans le même état et que tous ceux qui la suivent soient dans l'état opposé; le contenu de la fenêtre (F) pouvant avoir une configuration binaire mixte c'est à dire différente des deux précédentes; les différents états étant représentés par des champs variables à l'intérieur et à partir du début de la fenêtre, un champ ayant un nombre de positions binaires d'autant moins élevé que l'état qu'il représente se produit plus fréquemment, le passage d'un état à un état suivant se faisant sans décalage de la fenêtre, alors que pour le passage d'un état à un état précédent, la fenêtre est décalée d'un nombre de positions binaires d'autant plus faible que ledit état précédent se produit plus fréquemment, avec un décalage maximum égal à la longueur de la fenêtre.

2. Dispositif selon la revendication 1, caractérisé en ce que les moyens de codage (11) des états possibles du processus ont leurs sorties directement reliées au registre mémoire (3) et sont commandés sur leurs entrées d'une part par les signaux représentatifs de l'état du processus lu dans ladite fenêtre (F) et d'autre part, à partir des signaux représentatifs de l'état réel du processus qui est à mémoriser à l'intérieur de ladite fenêtre (F), de façon à mettre à jour l'état de la fenêtre (F) situé à l'intérieur de ladite mémoire (1).

3. Dispositif selon la revendication 1 ou 4, caractérisé en ce que ledit registre mémoire (3) est relié à des moyens de détection (4, 6) de la présence de ladite fenêtre (F) dans le registre de mémoire (3) pour transmettre l'état du processus lu dans ladite fenêtre à l'entrée desdits moyens de codage (11).

4. Dispositif selon la revendication 5, caractérisé en ce que lesdits moyens de détection sont constitués, d'un registre fenêtre (4) recopiant l'état du registre de mémoire (3), associé à des moyens de détection (6) des bits d'information de poids forts situés à l'intérieur de ladite fenêtre (F).

5. Dispositif selon l'une des revendications précédentes, caractérisé en ce que l'adresse de début de ladite fenêtre (F) est représentée par un nombre entier de positions binaires prédéterminées.

6. Dispositif selon l'une des revendications précédentes, caractérisé en ce qu'il est monté sur un support électronique portatif comprenant une mémoire (1) pour la mémorisation des différents états logiques d'un processus.

**Claims**

1. Device for storing logic states of a process comprising a memory (1) associated with means for writing and reading data in the said memory (1), the said data representing the state of the process, the said memory (1) being addressed from an address register (2) and being connected to the memory register (3) for reception of the contents of an information to be written or read in the memory at the locations selected by the addressing means (2), of the kind comprising means (11) for coding the possible states of the process, the states of a process coded by the coding means (11) being represented in the form of a series of binary configurations of a length variable as a function of each state, the lengths of these configurations being the shorter the more they correspond to possible states of the process occurring most frequently, characterised in that the successive states of the process are entered and analysed in the said memory (1) by means of a sliding write-read window (F) of a length which is a function of the number of possible states of the process, this window (F) being situated in the memory (1) in such a manner that all the binary numbers preceding the same are in the same state and that all those which follow the same are in the opposite state; the contents of the window (F) being able to have a composite binary configuration, that is to say different from the two preceding ones; the different states being represented by variable fields within and from the start of the window, a field having a number of binary locations which is the smaller the more often the state it represents occurs, the change from one state to the next state occurring without displacement of the window, whereas for changing from one state to a preceding state, the window is displaced by a number of binary locations which is the smaller the more often the said preceding state occurs, with a maximum displacement equal to the length of the window.

2. Device according to claim 1, characterised in that the means (11) for coding the possible states of the process have their outputs connected direct to the memory register (3) and are controlled via their inputs on the one hand by the signals representing the state of the process read in the said window (F), and on the other hand on the basis of the signals representing the true state of the process which is to be stored within the said window (F), in such manner as to disclose the state of the window (F) situated within the said memory (1).

3. Device according to claim 1 or 4, characterised in that the said memory register (3) is connected to means (4, 6) for detecting the presence of the said window (F) in the memory register (3) for transmission of the state of the process read in the said window to the input of the said coding means (11).

4. Device according to claim 5, characterised in that the said detection means comprise a window register (4) reproducing the state of the memory register (3) associated with means (6) for detection of the heavy weight bits of information situated within the said window (F).

5. Device according to any of the preceding claims, characterised in that the start address of the said window (F) is represented by a whole number of predetermined binary locations.

6. Device according to any of the preceding claims, characterised in that it is installed on a portable electronic support comprising a memory (1) for storage of the different logic state of a process.

**Patentansprüche**

1. Vorrichtung zur Speicherung von logischen Zuständen eines Prozesses, mit einem Speicher (1), dem Mittel zum Einschreiben und Auslesen von Informationen in dem genannten Speicher (1) zugeordnet sind, wobei die genannten Informationen den Prozesszustand darstellen, ferner der genannte Speicher (1) aus einem Adressenregister (2) adressiert wird und mit dem Speicherregister (3) verbunden ist, um den Inhalt einer Information zu empfangen, die im Speicher an Stellen geschrieben oder gelesen werden soll, welche durch die Adressiermittel (2) ausgewählt wurden, vom Typ mit Codiermitteln (11) zur Codierung der möglichen Prozesszustände, wobei die Zustände eines durch die Codiermittel (11) codierten Prozesses in Form einer Folge von Binärkonfigurationen dargestellt werden, deren Länge in Abhängigkeit von jedem Zustand variabel ist, wobei die Längen der genannten Konfigurationen je kürzer sind, desto häufiger die ihnen entsprechenden, möglichen Prozesszustände auftreten, dadurch gekennzeichnet, dass die aufeinanderfolgenden Prozesszustände in dem genannten Speicher (1) eingeschrieben und analysiert werden mittels eines gleitenden Schreib/Lese-Fensters (F), dessen Länge eine Funktion der Anzahl von möglichen Prozesszuständen ist, wobei dieses Fenster (F) in dem Speicher (1) derart liegt, dass alle ihm vorausgehenden Binärziffern sich in demselben Zustand befinden und dass alle daraufffolgenden den entgegensetzten Zustand aufweisen; wobei der Inhalt des Fensters (F) eine gemischte Binärkonfiguration aufweisen kann, d.h. verschieden von den beiden vorgenannten sein kann; wobei die verschiedenen Zustände durch variable Filter im Inneren und vom Beginn des Fensters ausgehend dargestellt werden, wobei ferner ein Feld eine Anzahl von Binärpositionen aufweist, die um so geringer ist, je häufiger der dadurch repräsentierte Zustand auftritt, wobei der Übergang von einem Zustand zu einem daraufffolgenden Zustand ohne Verschiebung des Fensters erfolgt, während das Fenster für den Übergang von einem Zustand zu einem vorausgehenden Zustand um eine Anzahl von Binärpositionen verschoben wird, die um so geringer ist, je häufiger der genannte vorausgehende Zustand auftritt, mit einer maximalen Verschiebung, die gleich der Länge des Fensters ist.

2. Vorrichtung nach Anspruch 1, dadurch gekennzeichnet, dass die Codiermittel (11) zur Codierung der möglichen Prozesszustände an ihren Ausgängen direkt mit dem Speicherregister (3) verbunden sind und an ihren Eingängen einerseits gesteuert werden durch die Signale, welche den Prozesszustand darstellen und aus dem genannten Fenster (F) ausgelesen werden, und andererseits durch Signale, welche den Realzustand des Prozesses darstellen, welcher im Inneren des genannten Fensters (F) gespeichert werden soll, so dass der Zustand des im Inneren des Speichers (1) gelegenen Fensters (F) aufgefrischt wird.

3. Vorrichtung nach Anspruch 1 oder 4, dadurch gekennzeichnet, dass das genannte Speicherregister (3) an Mittel (4, 6) zur Detektion der Anwesenheit des genannten Fensters (F) in dem Speicherregister (4) angeschlossen ist, um den aus dem genannten Fenster ausgelesenen Prozesszustand zum Eingang der genannten Codiermittel (11) zu übertragen.

4. Vorrichtung nach Anspruch 5, dadurch gekennzeichnet, dass die Detektionsmittel aus einem Fensterregister (4) gebildet sind, welches den Zustand des Speicherregisters (3) kopiert und Mitteln (6) zur Detektion der hochwertigen Informationsbits zugeordnet ist, die im Inneren des genannten Fensters (F) liegen.

5. Vorrichtung nach einem der vorstehenden Ansprüche, dadurch gekennzeichnet, dass die Anfangsadresse des genannten Fensters (F) durch eine ganze Anzahl von vorbestimmten Binärpositionen dargestellt wird.

6. Vorrichtung nach einem der vorstehenden Ansprüche, dadurch gekennzeichnet, dass sie auf einem tragbaren elektronischen Träger montiert ist, der einen Speicher (1) für die Speicherung der verschiedenen Logikzustände eines Prozesses umfasst.

E/S

μP

AD

D

M2a

2b

P1

M2

**FIG.1**

2

1

3

4

5

**FIG.2**

adresse paire

| 1 | 1 | 1 | | | | | | 0 | 0 | 0 | 0 | 0 |

F5

F2

F3

F4

F1

sens du glissement

**FIG.3**

FIG.4

FIG.5

sens de deplacement →

fenêtre 6 bits

| etat 0 | 1 | 1 | 0 | 0 | 0 | 0 | 0 | 0 | 0 | 0 |
| etat 1 | | | 1 | 0 | 0 | 0 | 0 | 0 | | |
| etat 2 | | | 1 | 0 | 1 | 0 | 0 | 0 | | |
| etat 3 | | | 1 | 0 | 1 | 0 | 1 | 0 | | |
| etat 4 | | | 1 | 0 | 1 | 1 | 1 | 0 | | |
| etat 5 | | | 1 | 0 | 1 | 1 | 1 | 1 | | |

états normaux

adresse paire

FIG. 6

FIG.7